Europäisches Patentamt

European Patent Office

Office européen des brevets

(19)

(11) Veröffentlichungsnummer: **0 319 609 B1**

(12) ## EUROPÄISCHE PATENTSCHRIFT

(45) Veröffentlichungstag der Patentschrift: **22.04.92**

(51) Int. Cl.⁵: **H03M 1/06**, H03M 1/74

(21) Anmeldenummer: **87118298.6**

(22) Anmeldetag: **10.12.87**

(54) **Digital/Analog-Wandler mit zyklischer Ansteuerung von Stromquellen.**

(43) Veröffentlichungstag der Anmeldung:
**14.06.89 Patentblatt 89/24**

(45) Bekanntmachung des Hinweises auf die
Patenterteilung:
**22.04.92 Patentblatt 92/17**

(84) Benannte Vertragsstaaten:
**DE FR GB IT NL**

(56) Entgegenhaltungen:
**EP-A- 0 135 274**
**EP-A- 0 253 950**
**FR-A- 2 349 874**
**GB-A- 2 080 059**

(73) Patentinhaber: **Deutsche ITT Industries GmbH
Hans-Bunte-Strasse 19 Postfach 840
W-7800 Freiburg i.Br.(DE)**

(72) Erfinder: **Reich, Werner, Dr. Ing.
Kleiststrasse 2a
W-7830 Emmendingen(DE)**

Rank Xerox (UK) Business Services

## Beschreibung

Bei der monolithischen Integration von hochgenauen Stromquellen für die Massenherstellung von Festkörperschaltungen besteht die Schwierigkeit, daß wegen der Herstellungsschwankungen der Stromquellen die von ihnen erzeugten Ströme einander nicht exakt gleich sind. Die Stromquellen werden z.B. durch die Kollektor-Emitter-Strecken von Bipolartransistoren oder die Source-Drain-Strecken von, insbesondere Isolierschicht-, Feldeffekttransistoren einer sogenannten Strombank realisiert, wobei die Basis- bzw. Gateanschlüsse auf ein gemeinsames konstantes Potential gelegt sind.

Nach "Electronics", 16. Juni 1983, Seiten 130 bis 134 und "Electronic Components and Applications", August 1980, Seiten 235 bis 241 wird die Stromungenauigkeit bei einem monolithisch integrierten Digital/Analog-Wandler (= D/A-Wandler) mit Bipolartransitoren für eine vierzehnstellige Dualzahl durch Verwendung eines Stromteilers weitgehend dadurch kompensiert, daß die Ströme einer Mehrzahl von Stromquellen mittels eines zyklischen Schieberegisters "rotierend" auf drei Stromwege geschaltet werden, wovon der erste und zweite den halben Strom des dritten erhält. Durch Kaskadenschaltung einer Mehrzahl solcher Stromteiler kann ein hochgenauer monolithisch integrierter D/A-Wandler realisiert werden.

In der eigenen, nichtvorveröffentlichten europäischen Patentanmeldung EP-A 0 253 950 ist ein monolithisch integrierter D/A-Wandler beschrieben, der ebenfalls von dem Prinzip des a.a.O. genannten "dynamic element matching" Gebrauch macht, wobei die gewichteten n-stelligen Binärsignale des zugeführten Datenwortes zunächst mittels eines Thermometer-Binär-Codewandlers in einen gleichgewichteten Code umgewandelt werden. Jeder Stelle dieses gleichgewichteten Thermometercodes entspricht eine einsschaltbare Stromquelle, wobei die maximale Anzahl der untereinander gleichen Stromquellen dem maximalen Zahlenwert der n-stelligen Binärzahl entspricht. Je nach dem Wert der zugeführten n-stelligen Binärzahl wird eine gleichgroße Anzahl dieser Stromquellen über Schalter auf einen Summierpunkt geführt, wobei die jeweilige Schalterstellung von der zugehörigen Stelle des Thermometercodes gesteuert wird. Zur "Rotation" der Stromquellen werden die Stromquellen nicht direkt vom Thermometer-Binär-Codewandler angesteuert, sondern von den einzelnen Stufen eines zyklisch geschalteten Schieberegisters, das zu Beginn jedes Rotationszyklusses mit dem jeweiligen Thermometercode geladen wird. Jedes Mal, wenn der im Schieberegister gespeicherte Thermometercode einmal vollständig umgelaufen ist, sind alle Stromquellen genau gleich oft angesteuert worden. Somit tragen alle Stromquellen gleich oft zum gemittelten Summensignal mit bei, wodurch die Differenzen der einzelnen Stromquellen vollständig ausgeglichen werden. Der von allen Stromquellen im Einschaltzustand gebildete Summenstrom ist nämlich ein feststehender Wert, der sich nicht ändert. Für die beschriebene "Rotation" der Stromquellen ist zwingend erforderlich, daß die einzelnen Stromflußzeiten untereinander gleich sind.

Die Frequenz des Schiebesignals des Schieberegisters muß mindestens $(2^n-1)$fach größer als die Frequenz des Abtastsignals sein, in dessen Takt die Binärsignale auftreten. Ein derartiges Schiebesignal steht jedoch nicht immer zur Verfügung, z.B. weil ein entsprechend frequenzstabiler Oszillator einen zu großen Aufwand erfordert. Außerdem liegt dann die Frequenz des Schiebesignals oft in solchen Frequenzbereichen, die ein besonders sorgfältiges Design und spezielle Herstellverfahren der integrierten Schaltung erforderlich machen. EP-A-0 253 950 gehört zum Stand der Technik gemäß Artikel 54(3) EPÜ und ist daher für die frage der erfinderische Tätigkeit nicht von Bedeutung. Aus EP-A 0 135 274 ist ebenfalls ein D/A-Wandler bekannt, der außer gewichteten Stromquellen eine bestimmte Anzahl von untereinander gleichen Stromquellen aufweist. Alle Stromquellen sind zur Erzeugung des analogen Ausgangssignals auf eine Summierstufe geschaltet. Die Ansteuerung der untereinander gleichen Stromquellen erfolgt über einen Thermometer-Binär-Codewandler, dessen Eingängen die höherwertigen Stellen des zu wandelnden Datenwortes zugeführt sind. Eine "Rotation" der Stromquellen ist bei dieser Anordnung jedoch nicht vorgesehen.

Die Aufgabe der im Patentanspruch angegebenen Erfindung besteht daher darin, den Grundgedanken der genannten nichtvorveröffentlichten älteren Anmeldung so zu modifizieren, daß die Frequenz des Taktsignals des Schieberegisters wesentlich niedriger liegen kann.

Die Erfindung geht von dem Grundgedanken aus, daß bei den meisten Analogsignalen, insbesondere z.B. bei Audiosignalen, Amplituden in der Nähe der Nullinie wesentlich häufiger auftreten als weiter von diesem Ruhewert ent fernte, insbesondere Maximalwerte. Da außerdem meist, in Audiosystemen immer, eine Übersteuerungsreserve vorhanden ist, treten im Binärsignal diejenigen Werte praktisch nie auf, die den maximal möglichen positiven und negativen Werten des Analogsignals entsprechen.

Ausgehen von dieser Grundüberlegung kann daher entsprechend der Erfindung das Schieberegister in eigenzyklische Teilschieberegister unterteilt werden, bei denen die Frequenz des Schiebesignals nur noch derjenige Teil des nach dem älteren Vorschlag erforderlichen Vielfachen der Frequenz des Abtastsignals zu sein braucht, der der Anzahl der Teilschieberegister entspricht. Diese sind allerdings vom Ausgang des Codewandlers in der im Patentanspruch angegebenen und noch im einzelnen zu erläuternden Weise anzusteuern.

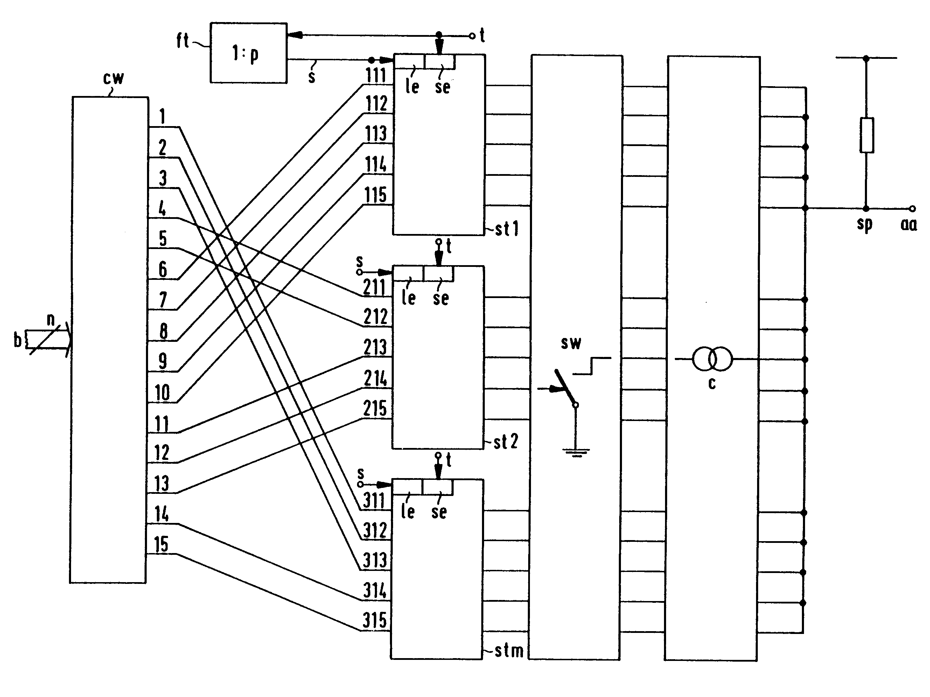

Die Erfindung wird nun anhand des in der Figur der Zeichnung dargestellten schematischen Blockschaltbilds eines Ausführungsbeispiels näher erläutert. In der Figur ist das Binärsignal b, das n-stellig ist und z.B. ein Audiosignal repräsentieren kann, dem Codewandler cw mit maximal $2^n-1$ Stufenausgängen zugeführt. Dieser wandelt es in ein binäres Signal mit einer zusammenhängenden Folge von gleichen Zuständen um, deren momentane Anzahl gleich dem Momentanwert des Binärsignals b ist. Der Code des binären Signals ist somit einer reiner Zählcode, bei dem per definitionem die Anzahl der Elemente gleich der Zahl der Zustände ist. Ein solcher Code ist z.B. der sogenannte Thermometercode, bei dem eine kontinuierliche Folge von Nullen oder von Einsen den Momentanwert des Binärsignals b angibt. Wenn also, wie im Ausführungsbeispiel, die fünfzehn Stufenausgänge 1...15 des Codewandlers cw eine Eins führen, so hat das Binärsignal b, wenn es z.B. im natürlichen Dualcode vorliegt, den Wert 1111 entsprechend dezimal 15. Hat es dagegen den Wert dezimal 8, so liegt an den Ausgängen 1...8 jeweils eine Eins (postive Logik) bzw. jeweils eine Null (negative Logik).

Im Ausführungsbeispiel der Figur, bei dem die Anzahl der Ausgänge ungerade ist, ist der Ausgang 8 der mittlere Ausgang, während dies bei einer geraden Anzahl von Ausgängen zwei benachbarte mittlere Ausgänge wären. Haben alle Ausgänge bis zu diesem mittleren Ausgang den erwähnten Zustand gleicher Art, also führen diese Ausgänge jeweils eine Null oder eine Eins, so kann dieser Ausgangszustand des Codewandlers cw als Nullinie oder Nullzustand sämtlicher Ausgangszustände angesehen werden, durch die das Analogsignal repräsentiert ist.

Dem Ausführungsbeispiels der Figur liegt ein konkretes Zahlenbeispiel zugrunde, daß nämlich die Stellenzahl n des Binärsignals b gleich 4 ist, daß ferner die Anzahl m der Teilschieberegister st1, st2, stm gleich 3 ist und demzufolge jedes Teilschieberegister p = $(2^n-1)/m$ = 5 Eingänge hat.

Daraus ergibt sich für das Frequenzverhältnis zwischen dem Abtastsignal s, das den Takt der Binärsignale b darstellt, und dem Taktsignal t, das als Schiebesignal der Teilschieberegister st... dient, ebenfalls die Zahl p. Zur Verdeutlichung dieses Zusammenhanges ist in der Figur der Frequenzteiler ft angegeben, der die Frequenz des Taktsignals t durch p teilt, so daß sich das Abtastsignal s ergibt, das dem jeweiligen Übernahmeeingang Ie der Teilschieberegister st... zugeführt ist.In der Figur ist aus Übersichtlichkeitsgründen nicht eigens gezeichnet, daß jedes Teilschieberegister st... dadurch ein eigenzyklisches ist, daß sein serieller Eingang mit seinem seriellen Ausgang verbunden ist.

Entsprechend der Erfindung sind die $2^n-1$ = 15 Ausgänge 1...15 des Codewandlers cw mit den drei Gruppen von je p = 5 Stufeneingängen der Teilschieberegister st1, st2, stm wie folgt verbunden: Ausgehend vom mittleren Ausgang 8 sind dieser und die jeweils beidseits benachbarten zwei Ausgänge 6, 7; 9, 10 mit den Eingängen 111...115 des ersten Teilschieberegisters st1 verbunden, d.h. einschließlich des mittleren Ausgangs 8 sind insgesamt p benachbarte Ausgänge erfaßt; mit den Stufeneingängen 211...215 des zweiten Teilschieberegisters st2 sind beidseits der ersten p Ausgänge wiederum insgesamt p Ausgänge des Codewandlers verbunden, nämlich die Ausgänge 4, 5; 11, 12, 13; schließlich sind nach der gleichen Gesetzmäßigkeit die Stufeneingänge 311...315 des dritten und letzten Teilschieberegisters stm mit den verbliebenen restlichen Ausgängen 1, 2, 3; 14, 15 des Codewandlers cw verbunden.

Durch diese erfindungsgemäße Verknüpfung der Stufenausgänge 1...15 des Codewandlers cw mit den Stufeneingängen 111...115; 211...215; 311...315 der drei Teilschieberegister st1, st2, stm wird erreicht, daß der D/A-Wandler für diejenigen p Ausgangszustände des Codewandlers cw, die statistisch am häufigsten auftreten, seine ideale Linearität aufweist. Erst außerhalb dieses Bereiches ergibt sich eine gewissen Nichtlinearität, die jedoch in Kauf genommen werden kann, da in dem Bereich,wo gerade die kleinen Analogsignale, also z.B. leise Audiosignale, auftreten, die Linearität vollständig gewahrt ist.

Das oben erwähnte "Rotieren" geschieht dadurch, daß zu Beginn jeder Periode das Abtastsignals s, das am Übernahmeeingang Ie der Teilschieberegister st...liegt, der dann gerade an den Ausgängen des Codewandlers cw liegende Zustand in die Teilschieberegister übernommen und während dieser Periodendauer "rotiert" wird. Zu Beginn der nächsten Periodendauer wird dann der nächste Zustand übernommen und anschließend "rotiert".

In der Figur ist schließlich schematisch angedeutet, daß jedem Stufenausgang der Teilschieberegister st... einer der Schalter sw mit nachgeordneter Stromquelle c zugeordnet ist. Dabei werden die Schalter sw vom jeweiligen Ausgangssignal der Teilschieberegister geöffnet oder geschlossen. Der Schalter selbst liegt dabei an geeigneter Stelle des Stromweges der zugehörigen Stromquelle, so daß der jeweilige Strom zum Summierpunkt sp durchgeschaltet oder davon abgeschaltet bzw. dem Summierpunkt zugeführt oder davon abgeleitet wird.

Schließlich ist in der Figur ebenfalls stark schematisiert die eingangs erwähnte Strombank von Stromquellen c angedeutet, deren Ströme alle zum Summierpunkt sp als dem Analogausgang aa des D/A-Wandlers führen. Dieser liegt beispielsweise über den gezeigten Widerstand an dem Potential der Betriebsspannungsquelle.

Für den Fall, daß bei der Wahl der Anzahl der Teilschieberegister sich ingesamt mehr Stufeneingänge als Ausgänge des Codewandlers cw ergeben, sind die überzähligen Stufeneingänge auf ein konstantes Potential zu legen. Dies wäre beispielsweise der Fall, wenn bei 15 Ausgängen des Codewandlers cw vier Teilschieberegister mit jeweils vier Eingängen gewählt würden, so daß ein Eingang übrig bliebe, der dann auf das genannte konstante Potential zu legen ist.

Der erfindungsgemäße D/A-Wandler wird bevorzugt monolithisch integriert realisiert, wobei insbesondere die bekannte MOS-Technik herangezogen werden kann. Er kann Teil einer größeren integrierten Schaltung sein, aber auch als selbständige integrierte Schaltung realisiert werden.

## Patentansprüche

1. Digital/Analog-Wandler für im Takt eines Abtastsignals (s) auftretende, ein Analogsignal repräsentierende n-stellige Binärsignale (b) mit
   - Schaltern (sw), die von den n-stelligen Binärsignalen (b) derart gesteuert sind, daß der konstante Strom einer jedem Schalter zugeordneten Stromquelle (c) zu einem Summierpunkt (sp) für alle Ströme als Analogausgang (aa) durchgeschaltet oder davon abgeschaltet bzw. dem Summierpunkt (sp) zugeführt oder davon abgeleitet wird,
   - einem zyklischen Schieberegister, von dem jeweils ein Stufenausgang einen Schalter steuert, wobei das zyklische Schieberegister aus m eigenzyklischen Teilschieberegistern (st1, ..., stm), besteht, denen ein Taktsignal (t) als Schiebesignal, dessen Frequenz das p-fache der Frequenz des Abtastsignals (s) ist wobei p eine ganze Zahl ist, für die gilt $p \geqq (2^{n-1})/m$ und deren Übernahmeeingang (le) das Abtastsignal zugeführt ist, und
   - einem Codewandler (cw) mit maximal $2^{n}-1$ Stufenausgängen, das Binärsignal (b) zugeführt ist und der es in ein binäres Signal mit einer zusammenhängenden Folge von gleichen Zuständen umwandelt, deren momentane Anzahl gleich dem Momentanwert des Binärsignals ist, wobei je ein Stufenausgang (im folgenden: Ausgang) (1, ..., 15) des Codewandlers (cw) mit je einem der p Stufeneingänge (im folgenden: Eingänge) (111, ..., 115; 211, ..., 215; 311, ..., 315) eines der Teilschieberegister (St ...) wie folgt verbunden ist:
   - ausgehend von dem bzw. den beiden mittleren Ausgängen (8) sind dieser bzw. diese und so viele beidseits benachbarte Ausgänge (6, 7; 9, 10), daß erste p-Ausgänge erfaßt sind, mit den Eingängen (111, ..., 115) des ersten Teilschieberegisters (st1) verbunden,
   - soviele beidseits den ersten p-Ausgängen benachbarte Ausgänge (4, 5; 11, 12, 13), daß zweite p-Ausgänge erfaßt sind, sind mit den Eingängen (211, ..., 215) des zweiten Teilschieberegisters (st2) verbunden,
   - und so weiter bis zum m-ten Teilschieberegister (stm), von dem übrigbleibende der p Eingänge auf einem konstanten Potential liegen.

## Claims

1. Digital-to-analog converter for n-digit binary signals (b) occurring at the pulse repetition rate of a sampling signal (s) and representing an analog signal, comprising
   - switches (sw) controlled by the n-digit binary signals (b) in such a way that the constant current of a current source (c) associated with each switch is switched to or disconnected from a summing point (sp) for all currents, which forms an analog output (a), or applied to or discharged from said summing point (sp),
   - a cyclic shift register each stage output of which controls one of the switches, the cyclic shift register consisting of m cyclic shift-register portions (st1, ..., stn) to which a clock signal (t) is applied as a shift signal having a frequency equal to p times the frequency of the sampling signal (s), where p is an integer greater than or equal to $(2^{n}-1)/m$, and whose enable inputs (le) are supplied with the sampling signal, and
   - a code converter (cw) having a maximum of $2^{n}-1$ stage outputs and fed with the binary signal (b) which is converted to a binary signal having a continuous sequence of a maximum of $2^{n}$ equal states whose instantaneous number is equal to the instantaneous value of the binary signal, with each stage output (hereinafter: output) (1, ..., 15) of the code converter (cw) connected to one of the p stage inputs (hereinafter: inputs) (111, ..., 115; 211, ..., 215; 311, ..., 315) of one of the shift-register portions (st...) as follows:

- the middle output (8) or the two middle outputs and so many adjacent outputs on both sides thereof (6, 7; 9, 10) that first p outputs are covered are connected to the inputs (111, ..., 115) of the first shift-register portion (st1);
- so many adjacent outputs (4, 5; 11, 12, 13) on both sides of the first p outputs that second p outputs are covered are connected to the inputs (211, ..., 215) of the second shift-register portion (st2),
- and so on up to the mth shift-register portion (stm), where remaining ones of the p inputs are connected to a constant potential.

## Revendications

1. Convertisseur numérique analogique pour des signaux binaires (b) à n chiffres, qui apparaissent à la cadence d'un signal d'échantillonnage (s) et représentent un signal analogique, comportant

- des interrupteurs (sw), qui sont commandés par les signaux binaires (b) à n chiffres de telle sorte que le courant constant d'une source de courant (c) associée à chaque commutateur est appliqué à un point de sommation (sp) prévu pour tous les courants, en tant que sortie analogique (aa) ou en est supprimé ou bien est envoyé au point de sommation (sp) ou en est prélevé,
- un registre à décalage cyclique, dont respectivement une sortie d'étage commande un interrupteur, le registre à décalage cyclique étant constitué de registres à décalage partiels à cycle propre (st1, ..., stm), auxquels un signal de cadence (t) est envoyé en tant que signal de décalage, dont la fréquence est le multiple p de la fréquence du signal d'échantillonnage (s), p étant un nombre entier pour lequel on a $p \geqq (2^n-1)/m$, et à l'entrée de prise en charge (le) desquels est envoyé le signal d'échantillonnage, et
- un convertisseur de code (cw) comportant au maximum $2^n-1$ sorties d'étages et auquel le signal binaire (b) est envoyé et qui convertit ce signal en un signal binaire possédant une suite continue d'états identiques, dont le nombre instantané est égal à la valeur instantanée du signal binaire, respectivement une sortie d'étage (ci-après : sortie) (1, ..., 15) du convertisseur de code (cw) étant raccordée de la manière suivante respectivement à l'une des p entrées d'étages (ci-après : entrées) (111, ..., 115; 211, ..., 215; 311, ..., 315) d'un registre à décalage partiel (st...) :

- à partir de la ou des deux sorties médianes (8), cette ou ces sorties et autant de sorties voisines des deux côtés (6,7; 9,10), qu'il existe de premières sorties p, sont raccordées aux entrées (111, ..., 115) du premier registre à décalage partiel (st1),
- autant de sorties (4,5; 11,12,13) voisines, des deux côtés, des premières sorties p, qu'il existe de secondes sorties p, sont raccordées aux entrées (211, ..., 215) du second registre à décalage partiel (st2),
- et ainsi de suite jusqu'au m-ème registre à décalage partiel (stm), dont les autres entrées faisant partie des p entrées sont placées à un potentiel constant.

EP 0 319 609 B1